# FASCICULE DE BREVET EUROPEEN

(11) **EP 0 646 806 B1**
(45) Date de publication et mention de la délivrance du brevet: **05.12.2001**
(21) Numéro de dépôt: 94402153.4
(22) Date de dépôt: 28.09.1994
(51) Int. Cl.: G01R 33/38, G01R 33/34

(54) **Structure magnétique ouverte**
Offene magnetische Struktur
Open magnetic structure

(30) Priorité: 30.09.1993 FR 9311673
(43) Date de publication de la demande: 05.04.1995
(73) Titulaire: COMMISSARIAT A L'ENERGIE ATOMIQUE, 75015 Paris Cédex 15 (FR)
(72) Inventeur: Locatelli, Marcel, F-38330 Montbonnot (FR); Jeandey, Christian, F-38120 Saint-Egreve (FR)
(74) Mandataire: Dubois-Chabert, Guy

(56) Documents cités:
- EP-A- 0 268 083
- EP-A- 0 371 775
- WO-A-92/07279
- US-A- 4 644 313
- US-A- 4 717 876
- US-A- 5 095 271

## Description

La présente invention concerne des structures magnétiques ouvertes destinées à la production de champs magnétiques et permettant, dans un volume déterminé, de contrôler le champ magnétique, notamment pour lui conférer une homogénéité donnée. Ce type de structures magnétiques est dit ouvert pour le différencier des structures dans lesquelles le volume utile (c'est-à-dire le volume dans lequel existe une homogénéité donnée du champ magnétique) est en grande partie entouré par la structure magnétique.

Le domaine d'application de ces structures magnétiques ouvertes est très varié. On les utilise en particulier dans des dispositifs mettant en oeuvre les phénomènes de résonance magnétique nucléaire (RMN) ou de résonance paramagnétique électronique (RPE). Ces dispositifs peuvent être employés dans la recherche scientifique, la médecine, l'industrie alimentaire, le contrôle non destructif, la recherche pétrolière ou minière.

Dans ce dernier domaine en particulier plusieurs configurations de structures magnétiques ouvertes ont été proposées et sont décrites dans les documents US-A-4 933 638 (Kenyon et al.), WO 92/10768 (Miller), US-A-4 717 878 (Taicher et al.), US-A-4 710 713 (Strikman) et US-A-4 350 955 (Jackson et al.). Ces structures utilisent des électro-aimants ou des aimants permanents comme source magnétique. L'homogénéité du champ magnétique désirée dans un volume déterminé est obtenue par la distribution particulière et la géométrie des sources.

On peut ainsi générer, dans une région d'une couche géologique, un champ magnétique statique homogène et exciter les noyaux des atomes de cette région par un signal électromagnétique transmis au moyen d'une antenne. Un récepteur connecté à l'antenne, ou l'antenne utilisée comme récepteur, permet de recueillir les signaux renvoyés par les atomes. Les signaux recueillis sont révélateurs de certaines propriétés de la couche examinée (porosité, perméabilité).

Un inconvénient de ces structures magnétiques ouvertes est que l'homogénéité du champ magnétique est obtenue par la distribution particulière des sources et leur géométrie. Pour obtenir une bonne homogénéité, les sources magnétiques doivent être éloignées du volume à observer. Elles ne sont donc pas utilisées d'une façon optimale quant à l'efficacité énergétique. L'induction magnétique obtenue est faible alors que le volume d'observation est grand. A titre d'exemple, pour un puits de forage de 100 mm de diamètre, un aimant permanent au Sm-Co de 1,2 T permet un volume d'observation de quelques dm³ et l'induction magnétique dans ce volume est d'environ 0,024 T.

La présente invention permet de remédier à cet inconvénient. Contrairement à l'art antérieur, le contrôle du champ magnétique, et le cas échéant son homogénéité, est obtenu à partir d'un circuit magnétique comportant des pièces polaires. Cette solution présente le grand avantage de séparer les fonctions source et contrôle du champ magnétique en amplitude et direction dans le volume d'observation. Ceci permet une meilleure optimisation de la structure que dans les dispositifs de l'art antérieur, en particulier du fait de la contrainte de l'espace disponible comme c'est le cas de la diagraphie en puits de forage (contrainte due à la géométrie et aux dimensions du puits). De fait, cela permet d'obtenir des inductions magnétique plus élevées (par rapprochement des pôles des sources magnétiques) et mieux contrôlées, ce qui se traduit, en particulier en RMN par un rapport signal sur bruit plus élevé. Les sources magnétiques utilisables peuvent être indifféremment des électro-aimants ou des aimants permanents.

Dans l'exemple du puits de forage cité plus haut, l'induction magnétique obtenue par une structure selon l'invention est de 0,1 T. Ce résultat pourrait être obtenu si on était capable de fabriquer une source magnétique possédant non seulement une géométrie de l'aimant telle qu'au niveau du volume examiné, l'aimant soit situé contra les parois du puits de forage, mais aussi une distribution d'aimantation de direction et d'amplitude contrôlées. Cela poserait des problèmes d'usinage des aimants. D'autre part, l'obtention d'une aimantation contrôlée par collage de matière aimantée de différentes directions d'aimantation est très difficilement envisageable.

L'invention a donc pour objet une structure magnétique ouverte telle que définie dans les revendications 1 et 2.

La structure peut comporter deux sources magnétiques alignées, deux pôles de même nature étant en vis-à-vis, chacun de ces deux pôles étant pourvu d'une pièce polaire dite pièce polaire principale intérieure pour la production dudit champ magnétique contrôlé, un espace en forme de V séparant lesdites pièces polaires principales intérieures, ladite région soumise au champ magnétique contrôlé étant située en regard de l'ouverture du V.

La structure peut comporter au moins une source magnétique auxiliaire possédant au moins une pièce polaire, l'ensemble étant placé à l'intérieur du V défini par les pièces polaires principales en regard à ladite région soumise au champ magnétique contrôlé.

L'invention a aussi pour objet un dispositif permettant l'analyse d'une région déterminée au moyen de champs magnétiques, caractérisé en ce qu'il comprend une structure telle que définie ci-dessus pour la production d'un champ magnétique intense, statique et homogène dans ladite région déterminée, et des moyens permettant l'émission d'un signal électromagnétique vers ladite région déterminée et la réception du signal de réponse de ladite région déterminée au signal émis.

Pour une utilisation comme dispositif d'imagerie magnétique de surface, il peut comprendre, dans l'espace en forme de V, des bobines de gradient pour les directions de l'espace x, y et éventuellement z, z étant la direction du champ magnétique contrôlé dans la région déterminée.

L'invention sera mieux comprise et d'autres avantages et particularités apparaîtront à la lecture de la description qui va suivre, donnée à titre d'exemple non limitatif, accompagnée des figures annexées parmi lesquelles :
- la figure 1 illustre de façon schématique une structure magnétique ouverte selon l'invention,
- la figure 2 est une variante de la structure magnétique ouverte représentée à la figure 1,
- la figure 3 illustre de façon schématique une première variante de structure magnétique ouverte à deux sources magnétiques, selon l'invention,
- la figure 4 illustre de façon schématique une seconde variante de structure magnétique ouverte à deux sources magnétiques, selon l'invention,
- la figure 5 est une vue selon la coupe V-V de la figure 4,
- la figure 6 représente une antenne haute fréquence utilisable pour les structures magnétiques ouvertes représentées aux figures précédentes,
- la figure 7 représente un écran électromagnétique utilisable pour une structure magnétique ouverte selon l'invention,
- la figure 8 représente une antenne haute fréquence utilisable pour des structures magnétiques selon l'invention,
- la figure 9 représente une autre antenne haute fréquence utilisable pour des structures magnétiques selon l'invention,
- la figure 10 montre un détail de structure magnétique ouverte selon la seconde variante, comportant une source magnétique supplémentaire,
- la figure 11 représente un dispositif de diagraphie en puits de forage,
- la figure 12 représente une configuration pour imagerie magnétique de surface selon l'invention,
- la figure 13 représente un imageur magnétique de surface dont la tête est vue en coupe, selon l'invention.

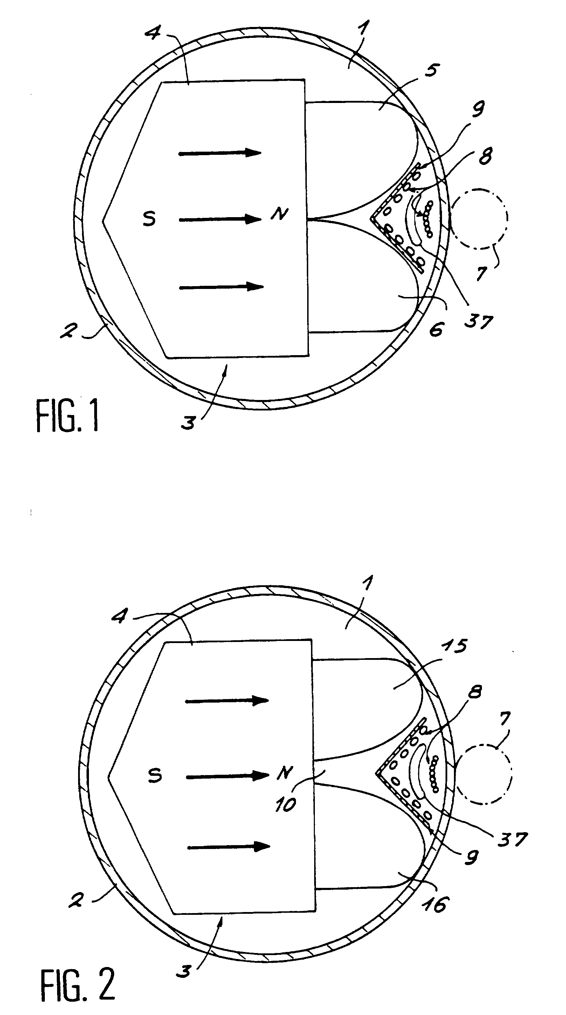

A la figure 1, on a représenté une structure magnétique ouverte selon l'invention, utilisable pour la recherche pétrolière. La structure est représentée en coupe transversale selon l'axe vertical du puits 1 dont le dépôt de boue sur la paroi interne du puits est représenté sous la référence 2. La structure magnétique 3 comprend une source magnétique 4 et deux pièces polaires 5 et 6 fixées sur l'un des pôles de la source magnétique 4. L'autre pôle de la source magnétique est laissé découvert mais possède une forme permettant de combler autant que possible le puits 1.

Cette structure magnétique correspond à une application pour la mesure des temps de relaxation des protons de l'eau ou des hydrocarbures en vue de déterminer la porosité et la perméabilité du terrain. La source magnétique 4 est de préférence constituée par des aimants permanents en samarium-cobalt, résistant à des températures supérieures à 200°C. L'aimantation est perpendiculaire à l'axe du puits. L'induction magnétique homogène (quelques %) dans la zone 7 de la couche géologique est obtenue grâce à la géométrie des pièces polaires 5 et 6 en matériau magnétique doux (fer doux, tôles au silicium ou ferrite doux). L'épaisseur des pièces polaires selon l'axe du puits définit l'épaisseur de la zone homogène 7 (le volume utile).

A titre d'exemple, une induction de l'ordre de 0,05 T avec une homogénéité de l'ordre de 1% peut être produite dans une région dont le centre se trouve à une distance de 15 mm à l'intérieur de la formation géologique. La zone homogène 7 constitue un cylindre parallèle à l'axe du trou 1, de 20 mm de diamètre et de 300 mm de hauteur pour un diamètre du puits de l'ordre de 100 mm.

Les différentes géométries possibles pour les pièces polaires découlent de calculs mathématiques et de l'expérience de l'homme du métier en considérant, en première approximation, que les faces libres des pièces polaires sont des équipotentielles magnétiques.

Entre les deux pièces polaires 5 et 6 et en regard de la zone 7 est prévue une antenne 8 permettant de transmettre un signal électromagnétique haute fréquence d'excitation aux noyaux des atomes de cette zone. L'antenne 8 permet également de détecter la réponse des noyaux au signal d'excitation. Une antenne 37, de polarisation en quadrature avec celle de l'antenne 8, donc découplée électromagnétiquement, mais couplée au signal utile des noyaux, de même que l'antenne 8, peut aussi être utilisée. La présence des pièces polaires 5 et 6 peut perturber le signal HF transitant par la ou les antennes. Cette perturbation se manifeste par l'apparition de courants de Foucault lorsque les pièces polaires sont en fer doux. On peut remédier à cet inconvénient en utilisant des matériaux tels que les tôles en silicium ou le ferrite doux pour réaliser les pièces polaires. Une autre solution consiste à placer un écran électromagnétique 9 entre l'antenne 8 et les pièces polaires 5 et 6. On peut encore donner une géométrie adaptée à la ou les antennes pour éviter le couplage électromagnétique entre la ou les antennes et les pièces polaires.

Sur la figure 1, les pièces polaires 5 et 6 sont représentées adjacentes. Ceci n'est pas impératif. La figure 2 montre une variante de réalisation où les pièces polaires 15 et 16 sont séparées entre elles par un écart 10 dont la valeur est à prendre en considération pour le calcul des formes des pièces polaires.

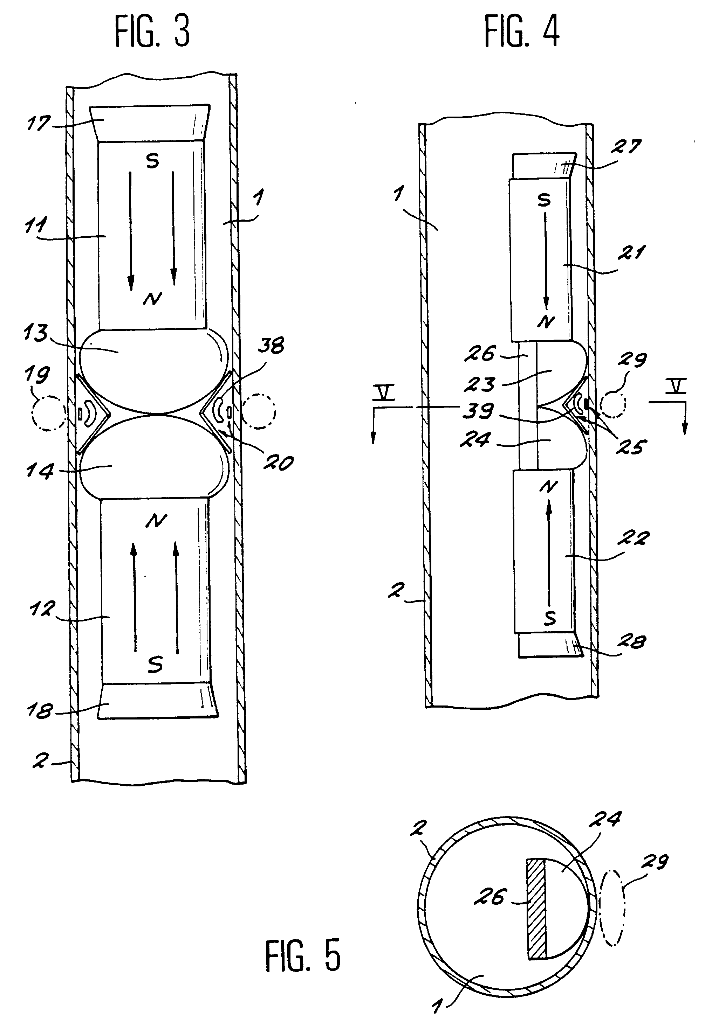

La figure 3 correspond à une structure permettant d'obtenir une induction magnétique plus élevée que précédemment, donc une meilleure sensibilité. Dans ce cas, la direction de l'aimantation est parallèle à l'axe du puits 1 ce qui permet d'augmenter la longueur de la source magnétique donc l'induction utile. En fait, la structure comporte deux sources magnétique 11 et 12 disposées dans l'axe du trou 1 et dont deux pôles de nature identique sont en vis-à-vis. Chaque pôle est pourvu d'une pièce polaire. Les sources magnétiques 11 et 12 sont pourvues de pièces polaires principales 13 et 14 adjacentes. Les autres extrémités sont pourvues de pièces polaires 17 et 18. Les pièces polaires 13, 14, 17 et 18 peuvent être en fer doux, en tôles au silicium ou en ferrite doux. Les pièces polaires 17 et 18 ne sont pas obligatoires. Elles permettent un meilleur contrôle de l'homogénéité de l'induction magnétique dans la zone homogène 19.

Si les pièces polaires principales 13 et 14 intérieures à la structure sont en ferrite, il n'est pas nécessaire de placer un écran électromagnétique entre elles et la ou les antennes 20 et 38. Les pièces polaires 17 et 18 extérieures peuvent avantageusement être en fer doux pour des raisons économiques.

La zone d'induction contrôlée 19 est toroïdale. Ce peut être un tore complet ou un tore limité à un secteur angulaire selon que les pièces polaires principales 13 et 14 sont des pièces de révolution autour de l'axe du puits 1 ou qu'elles sont limitées à un secteur angulaire. La figure 3 correspond à un outil de diagraphie centré dans le puits.

Les figures 4 et 5 illustrent le cas d'un outil de diagraphie non centré dans le puits contrairement à celui de la figure 3. Cet outil est utilisé plaqué sur la paroi du puits et peut donc convenir pour des puits de différents diamètres. La disposition et la nature des différents éléments composant cette structure sont identiques à la structure décrite par la figure 3. On reconnaît les sources magnétiques 21 et 22, les pièces polaires principales intérieures 23 et 24, les pièces polaires extérieures 27 et 28 et la ou les antennes 25 et 39. Les pièces polaires principales intérieures 23 et 24 font partie d'un même bloc comprenant également la semelle 26.

La configuration des structures représentées aux figures 4 à 6 permet d'obtenir des inductions utiles de l'ordre de 0,1 T dans la zone 29 à partir d'aimants permanents samarium-cobalt pour des volumes utiles toroïdaux complets ou sectoriels, de section rectangulaire 20 mm x 20 mm, pour un diamètre moyen de l'ordre de 140 mm et avec une homogénéité de quelques %.

Ces deux types de structures permettent la mesure du temps de relaxation des protons excités par un signal haute fréquence. Ce signal est délivré par la ou les antennes HF 25 et 39 qui recueillent également le signal renvoyé par la formation géologique.

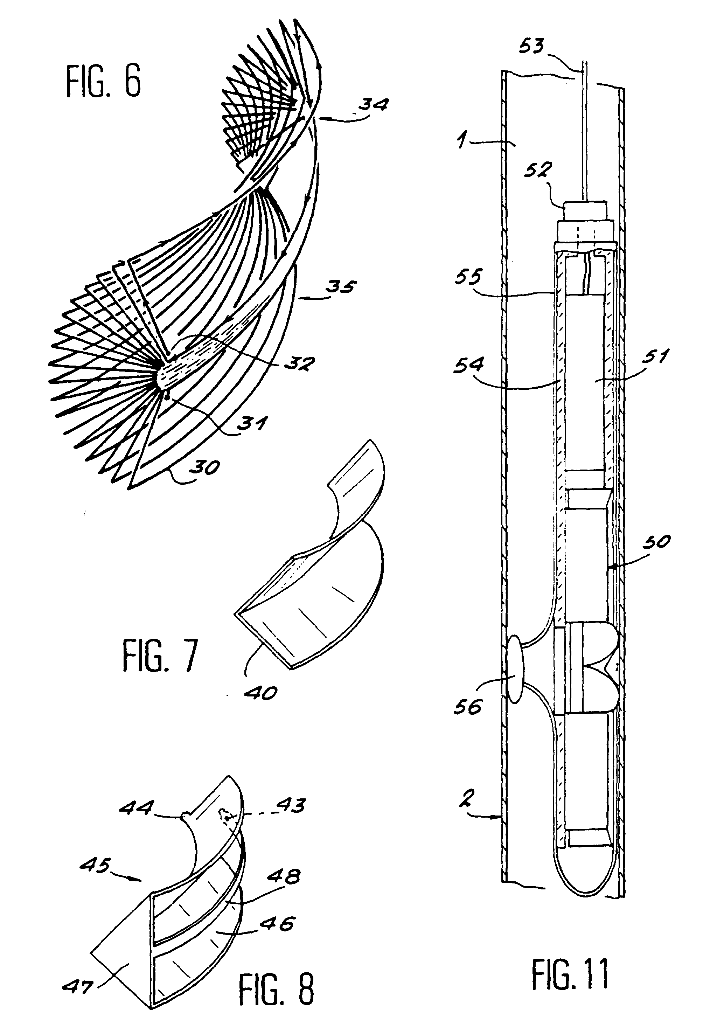

Une antenne haute fréquence utilisable, en particulier pour la réception, pour les structures décrites ci-dessus peut être celle représentée à la figure 6. Cette antenne est réalisée à partir d'un fil conducteur électrique 30, par exemple en cuivre ou en argent, bobiné de façon à produire une induction radio-fréquence perpendiculaire à l'induction statique. Les références 31 et 32 représentent les deux extrémités du fil 30. L'antenne ainsi réalisée est rigidifiée par un matériau de remplissage amagnétique et est installée dans le V constitué par la réunion des pièces polaires adjacentes. Les faces 34 et 35 sont situées en vis-à-vis de la paroi du puits.

La figure 7 représente un écran électromagnétique du type utilisable notamment pour les structures des figures 1 et 2. Cet écran est réalisé à partir d'une feuille conductrice de l'électricité 40, par exemple en cuivre ou en argent. Il est placé entre l'antenne et les pièces polaires correspondantes, en contact électrique ou non avec les pièces polaires. Il épouse la forme des pièces polaires.

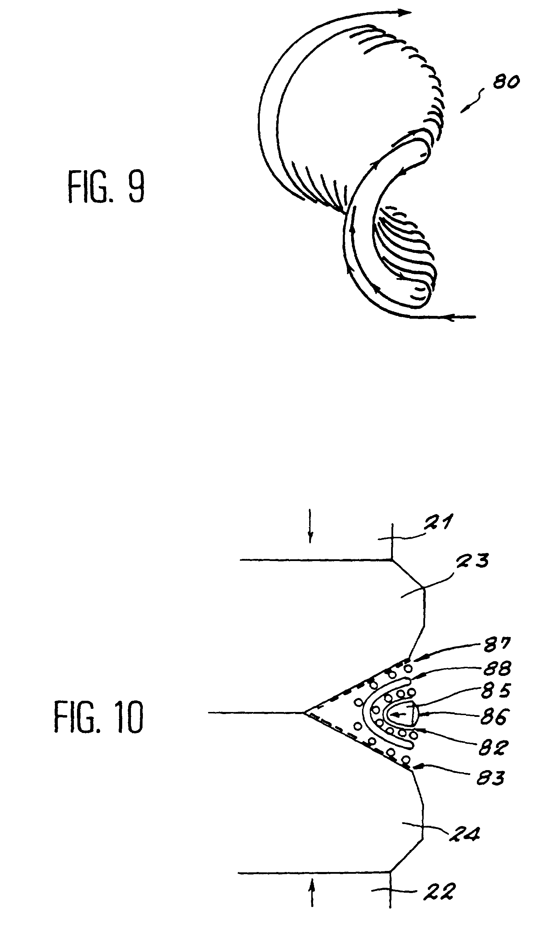

Dans le cas des structures représentées aux figures 3 à 5, on peut utiliser une antenne, en particulier pour la réception, telle que celle représentée à la figure 8. L'antenne 45 est réalisée à partir d'un matériau conducteur électrique, par exemple en cuivre ou en argent, et reproduit la forme des pièces polaires en vis-à-vis. Avantageusement, une feuille perforée ou un grillage est utilisé pour limiter les effets électroacoustiques qui peuvent produire un signal HF parasite. L'antenne comprend une partie 46 en forme de gouttière recourbée et fermée à l'une de ses extrémités. A l'élement de fermeture 47 se rattache une lame 48 située dans le plan de symétrie de la partie 46 et reproduisant sa forme recourbée. L'extrémité libre 43 de la lame 48 et l'extrémité 44 de la partie 46 en vis-à-vis permettent de raccorder électriquement l'antenne à un circuit d'émission et de réception. L'antenne est rigidifiée par un matériau de remplissage, par exemple amagnétique.

La figure 9 représente une antenne utilisée en particulier pour l'émission, de polarisation quadratique à celle de l'antenne 8 plutôt utilisée pour la réception car mieux couplée au signal des noyaux. L'antenne 80 est réalisée en fil de cuivre ou d'argent bobiné sur un support rigide et est intégrée ou non dans l'antenne 8. Cette antenne peut bien sûr être utilisée seule pour l'émission et la réception. Elle peut se situer à l'intérieur ou à l'extérieur de l'antenne 8, l'entourer ou non.

La figure 10 illustre le cas d'un outil de diagraphie non centré. Par rapport à la structure montrée aux figures 4 et 5, cette structure comporte en plus une source magnétique 85 d'aimantation opposée à la direction de l'induction d'origine dans l'espace en V. Cette source magnétique 85 peut être constituée par un aimant Sm-Co par exemple. Une pièce polaire 86 lui est associée. Cet ensemble permet de situer la zone à champ contrôlé plus profondément dans le terrain : 30 mm au lieu de 15 mm pour une induction de 0,07 T au lieu de 0,1 T. La géométrie de la ou des antennes 87, 88 est adaptée à la nouvelle configuration. De fait, les antennes se situent dans l'espace libre entre les pièces polaires principales 23 et 24 et l'ensemble aimant 85 - pièce polaire 86. Cet ensemble est composé de matériaux métalliques dont la présence est susceptible de perturber le signal HF du fait des courants de Foucault qui peuvent être générés dans les métaux si des précautions ne sont pas prises. Comme précédemment, des écrans électromagnétiques peuvent être utilisés : un écran 82 pour séparer l'ensemble aimant 85- pièce polaire 86 des autres antennes et un écran 83 pour séparer les pièces polaires principales 23 et 24 des antennes. Ces écrans 82 et 83 peuvent être constitués d'une mince feuille perforée ou non, ou d'un grillage en matériau bon conducteur électrique (cuivre ou argent par exemple).

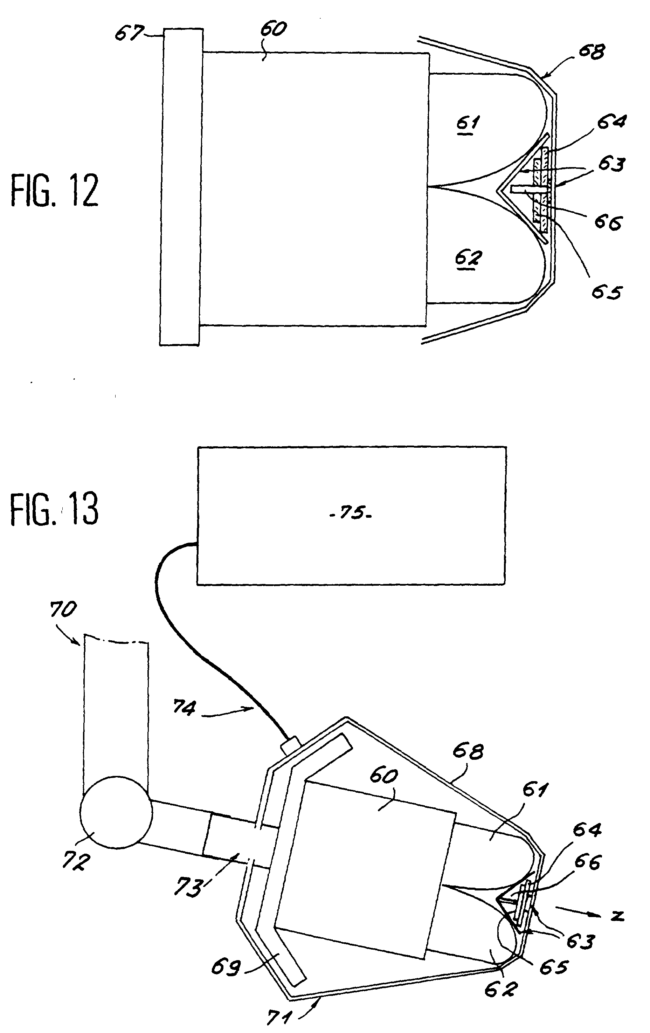

La figure 11 représente un dispositif de diagraphie en puits de forage du type correspondant aux figures 4 et 5. Le dispositif comprend une structure magnétique ouverte repérée globalement sous la référence 50 et dont tous les éléments ont été décrits plus haut. Le dispositif comprend aussi un circuit électronique 51 qui est un circuit utilisé classiquement dans les opérations de diagraphie. Il est relié d'une part à l'antenne de la structure 50 et d'autre part à un câble électrique 53 grâce au connecteur 51. Le câble 53 permet de relier électriquement le dispositif de diagraphie aux installations de surface. Il permet également de supporter le dispositif. Un support mécanique amagnétique 54 assure le maintien de la structure magnétique ouverte 50 et du circuit électronique 51 et constitue avec la gaine amagnétique 55 l'enveloppe du dispositif qui est ainsi rendu étanche à la boue se trouvant dans le puits 1. Un patin amagnétique 56 permet de plaquer la structure magnétique 50 contre la paroi du puits.

La structure magnétique ouverte selon l'invention peut également être utilisée en imagerie magnétique de surface. Cette imagerie implique une homogénéité en induction de l'ordre de quelques dizaines de parties par million, ce qui implique l'utilisation de bobines de correction de l'induction. Elle implique également la description de l'ensemble du volume à observer de façon que la valeur de l'induction corresponde à la valeur de résonance dans un volume élémentaire donné, ce qui donne la résolution. Ceci est généralement réalisé par la mise en oeuvre de gradients d'induction magnétique suivant les trois directions de l'espace x, y et z.

La figure 12 représente une configuration pour imagerie magnétique de surface. Le dispositif comprend une source magnétique 60 constituée par un aimant permanent. Deux pièces polaires 61 et 62 sont fixées sur l'un des pôles de la source magnétique 60. La forme de ces pièces polaires est définie comme précédemment pour obtenir l'homogénéité voulue de l'induction. Dans le V formé par les pièces polaires 61 et 62, on installe la ou les antennes 63, les bobines classiques de correction d'induction 65 et de gradient portant la référence globale 64 ainsi que la source magnétique 66, associée à une pièce polaire, de correction d'induction. La géométrie de l'ensemble peut être parallélépipédique ou cylindrique avec ou sans contre-pièce polaire, telle que la pièce polaire 67, de géométrie variée.

La source magnétique 66 de correction d'induction peut être au samarium-cobalt, au néodyme-fer-bore, en ferrite dur. La pièce polaire associée peut être en fer doux, en fer au silicium ou en ferrite.

Un capot 68, en matériau isolant électrique et amagnétique (par exemple en matériau composite verre-résine époxy) recouvre la partie de la structure comportant les pièces polaires 61 et 62.

Les bobines 64 permettent l'obtention de gradients d'induction selon les directions x, y et aussi z. L'obtention du gradient selon l'axe z est le plus délicat. Une solution mécanique de balayage suivant l'axe z consiste à déplacer la structure magnétique par rapport au volume à observer. Le déplacement de la structure magnétique se fait alors selon l'axe d'aimantation de la source magnétique 60.

Des inductions de l'ordre de 0,03 à 0,12 T peuvent être obtenues à partir de sources magnétiques en aimants permanents tels que le ferrite dur, le samarium-cobalt ou le néodyme-fer-bore pour des volumes utiles centrés à 15 mm de l'extrémité des pièces polaires et de section 20 mm x 20 mm pour les systèmes parallélépipédiques, et pour des volumes cylindriques de 20 mm de diamètre de base et de 20 mm de hauteur.

La figure 13 représente un imageur magnétique de surface. On y reconnaît, formant la tête 71 de l'imageur, la source magnétique 60, les pièces polaires 61 et 62, l'antenne 63, les bobines de gradient 64, les bobines de correction d'induction 65 et la source magnétique de correction d'induction 66 associée à sa pièce polaire. Dans cet exemple, la contre-pièce polaire 69 présente une forme différente de celle de la figure 10. Le dispositif comporte un support mécanique 70 pour le maintien de la tête 71 qui peut être rendue orientable par une rotule 72.

Un mécanisme de déplacement 73 de type connu permet le déplacement longitudinal de la structure magnétique selon l'axe z, à l'intérieur du capot 68.

La tête orientable 71 est reliée par l'intermédiaire d'un câble électrique 74 à l'appareillage électronique 75 utilisé classiquement pour la commande de l'imageur.

## Revendications

1. Structure magnétique ouverte pour la production d'un champ magnétique homogène, intense et stable, contrôlé en amplitude et en direction dans une région adjacente à cette structure, comprenant une source magnétique (4), **caractérisée en ce qu'**elle comprend en outre une ou plusieurs pièce(s) polaire(s) (5,6) qui est (sont) fixée(s) sur l'un des pôles de la source magnétique, la source magnétique et la (les) pièce(s) polaire(s) étant adaptée(s) pour produire le champ magnétique homogène, la (les) pièce(s) polaire(s) présentant une partie creuse constituant un espace en forme générale de V, ladite région soumise au champ magnétique homogène étant située en regard de l'ouverture du V.

2. Structure magnétique ouverte pour la production d'un champ magnétique homogène, intense et stable, contrôlé en amplitude et en direction dans une région adjacente à cette structure, comprenant deux sources magnétiques alignées, deux pôles de même nature étant en vis-à-vis, **caractérisée en ce que** chacun de ces deux pôles est pourvu d'une pièce polaire (13, 14) dite pièce polaire principale intérieure, les deux sources magnétiques et les pièces polaires étant adaptées pour produire le champ magnétique homogène, lesdites pièces polaires principales intérieures étant séparées par un espace en forme générale de V, ladite région soumise au champ magnétique homogène étant située en regard de l'ouverture du V.

3. Structure selon la revendication 2, **caractérisée en ce qu'**une source magnétique auxiliaire de polarisation (85) non alignée avec les deux sources magnétiques alignées (21, 22) est située dans l'espace en forme de V, lesdites pièces polaires principales intérieures (23, 24) et la source magnétique auxiliaire (85) produisant un champ magnétique contrôlé dans ladite région.

4. Structure selon la revendication 3, **caractérisée en ce qu'**une pièce polaire (86) est associée à la source magnétique auxiliaire (85) et a une forme calculée de façon à contrôler ledit champ magnétique produit.

5. Dispositif permettant l'analyse d'une région déterminée au moyen de champs magnétiques, **caractérisé en ce qu'**il comprend une structure selon l'une quelconque des revendications 1 à 4 pour la production d'un champ magnétique intense, statique et homogène dans ladite région déterminée, et des moyens (8, 20, 25, 37, 38, 39, 63, 87, 88) permettant l'émission d'un signal électromagnétique vers ladite région déterminée et la réception du signal de réponse de ladite région déterminée au signal émis.

6. Dispositif selon la revendication 5, **caractérisé en ce que** lesdits moyens d'émission et de réception sont constitués par au moins une antenne disposée dans ledit espace en forme de V.

7. Dispositif selon la revendication 6, **caractérisé en ce que** l'antenne est constituée à partir d'un fil (30) conducteur électrique et qu'elle est rigidifiée par un matériau amagnétique.

8. Dispositif selon la revendication 6, **caractérisé en ce que** l'antenne (45) est constituée d'une partie (46) en forme de gouttière fermée à l'une de ses extrémités par un élément (47) auquel est rattachée une lame (48), l'extrémité libre (44) de la gouttière et l'extrémité libre (43) de la lame constituant les connexions électriques de l'antenne.

9. Dispositif selon l'une quelconque des revendications 5 à 8, **caractérisé en ce qu'**il comprend un écran électromagnétique (9, 82, 83) entre i'antenne (8, 87, 88) et la ou les pièces polaires voisines (5, 6, 23, 24, 86) et éventuellement ladite source magnétique auxiliaire (85).

10. Dispositif selon la revendication 9, **caractérisé en ce que** l'écran électromagnétique est constitué à partir d'une feuille électriquement conductrice (40).

11. Dispositif selon l'une quelconque des revendications 5 à 10, **caractérisé en ce que**, pour une utilisation comme dispositif d'imagerie magnétique de surface, il comprend, dans l'espace en forme de V, des bobines de gradient (64) pour les directions de l'espace x, y et éventuellement z, z étant la direction du champ magnétique homogène dans la région déterminée.

12. Dispositif selon la revendication 11, **caractérisé en ce qu'**il comprend en outre des moyens (65, 66) de correction de l'induction magnétique dans la région déterminée, ces moyens de correction étant situés dans l'espace en forme de V.

13. Dispositif selon l'une des revendications 11 ou 12, **caractérisé en ce qu'**il comporte des moyens de déplacement (73) de la structure magnétique pour produire le gradient d'induction selon la direction z.

## Patentansprüche

1. Offene magnetische Struktur zur Erzeugung eines homogenen, starken und stabilen Magnetfelds, amplituden- und richtungsgesteuert in einem dieser Struktur benachbarten Bereich, eine Magnetquelle (4) umfassend,
**dadurch gekennzeichnet,**
**dass** sie außerdem ein (oder mehrere) Polstück(e) (5, 6) umfasst, das (die) an einem der Pole der Magnetquelle befestigt ist (sind), wobei die Magnetquelle und das (die) Polstück(e) geeignet ist (sind), das homogene Magnetfeld zu erzeugen, das (die) Polstück(e) einen hohlen Teil aufweist (aufweisen), der einen im Wesentlichen V-förmigen Raum bildet, und der genannte, dem homogenen Magnetfeld ausgesetzte Bereich der Öffnung des V gegenübersteht.

2. Offene magnetische Struktur zur Erzeugung eines homogenen, starken und stabilen Magnetfelds, amplituden- und richtungsgesteuert in einem dieser Struktur benachbarten Bereich, zwei fluchtende Magnetquellen umfassend, wobei sich zwei gleichartige Pole gegenüberstehen,
**dadurch gekennzeichnet,**
**dass** jeder dieser beiden Pole mit einem Polstück (13, 14) versehen ist, inneres Hauptpolstück genannt, die beiden Magnetquellen und die Polstücke geeignet sind, das homogene Magnetfeld zu erzeugen, und die beiden inneren Hauptpolstücke getrennt sind durch einen im Wesentlichen V-förmigen Raum, wobei der genannte, dem homogenen Magnetfeld ausgesetzte Bereich der Öffnung des V gegenübersteht.

3. Struktur nach Anspruch 2, **dadurch gekennzeichnet, dass** eine mit den beiden fluchtenden Magnetquellen (21, 22) nicht fluchtende Poiarisations-Hilfsmagnetquelle (85) sich in dem V-förmigen Raum befindet, wobei die genannten inneren Hauptmagnetstücke (23, 24) und die Hilfsmagnetquelle (85) ein in dem genannten Bereich erzeugtes Magnetfeld steuern.

4. Struktur nach Anspruch 3, **dadurch gekennzeichnet, dass** ein Polstück (86) der Hilfsmagnetquelle (85) zugeordnet ist und eine Form aufweist, die so berechnet ist, dass sie das genannte erzeugte Magnetfeld steuert.

5. Vorrichtung zur Analyse eines festgelegten Bereichs mit Hilfe von Magnetfeldern, **dadurch gekennzeichnet, dass** sie eine Struktur nach einem der Ansprüche 1 bis 4 zur Erzeugung eines starken, statischen und homogenen Magnetfelds in dem genannten festgelegten Bereich und Einrichtungen (8, 20, 25, 37, 38, 39, 63, 87, 88) umfasst, die das Senden eines elektromagnetischen Signals in Richtung des genannten festgelegten Bereichs und das Empfangen des Antwortsignals des genannten festgelegten Bereichs auf das gesendete Signal ermöglichen.

6. Vorrichtung nach Anspruch 5, **dadurch gekennzeichnet, dass** die genannten Sende- und Empfangseinrichtungen gebildet werden durch wenigstens eine in dem genannten V-förmigen Raum angeordnete Antenne.

7. Vorrichtung nach Anspruch 6, **dadurch gekennzeichnet, dass** die Antenne durch einen elektrisch leitfähigen Draht (30) gebildet wird und durch ein unmagnetisches Material versteift wird.

8. Vorrichtung nach Anspruch 6, **dadurch gekennzeichnet, dass** die Antenne (45) gebildet wird durch einen rinnenförmigen Teil (46), an einem seiner Enden geschlossen durch ein Element (47), an dem ein dünner Streifen (48) befestigt ist, wobei das freie Ende (44) der Rinne und das freie Ende (43) des dünnen Streifens die elektrischen Verbindungen der Antenne bilden.

9. Vorrichtung nach einem der Ansprüche 5 bis 8, **dadurch gekennzeichnet, dass** sie eine elektromagnetische Abschirmung (9, 82, 83) zwischen der Antenne (8, 87, 88) und dem oder den benachbarten Polstücken (5, 6, 23, 24, 86) und eventuell der genannten Hilfsmagnetquelle (85) umfassen.

10. Vorrichtung nach Anspruch 9, **dadurch gekennzeichnet, dass** die elektromagnetische Abschirmung durch eine elektrisch leitfähige Tafel bzw. Platte (40) gebildet wird.

11. Vorrichtung nach einem der Ansprüche 5 bis 10, **dadurch gekennzeichnet, dass** sie für eine Verwendung als magnetische Flächenabbildungs- bzw. bildherstellungsvorrichtung in dem V-förmigen Raum Gradienten-Spulen (64) für die Raumrichtungen x, y und eventuell z umfasst, wobei z die Richtung des homogenen Magnetfelds in dem festgelegten Bereich ist.

12. Vorrichtung nach Anspruch 11, **dadurch gekennzeichnet, dass** sie außerdem Korrektureinrichtungen (65, 66) der magnetischen Induktion in dem festgelegten Bereich umfasst, wobei diese Korrektureinrichtungen sich in dem V-förmigen Raum befinden.

13. Vorrichtung nach einem der Ansprüche 11 oder 12, **dadurch gekennzeichnet, dass** sie Verschiebungseinrichtungen (73) der magnetischen Struktur umfasst, um den Induktionsgradienten in der z-Richtung herzustellen.

## Claims

1. Open magnetic structure for producing an intense, stable, homogeneous magnetic field, which is controlled in amplitude and direction in a region adjacent to said structure, having at least one magnetic source (4), **characterized in that** it also comprises one or more pole pieces (5, 6) fixed to one of the poles of the magnetic source, the magnetic source and the pole piece or pieces being able to produce the homogeneous magnetic field, the pole piece or pieces having a hollow portion constituting a generally V-shaped space, said region subject to the homogeneous magnetic field facing the opening of the V.

2. Open magnetic structure for producing an intense, stable, homogeneous magnetic field, which is controlled in amplitude and direction in a region adjacent to said structure, having two aligned magnetic sources, two poles of the same nature facing one another, **characterized in that** each of said two poles is provided with a pole piece (13, 14), known as the internal, main pole piece, the two magnetic sources and the pole pieces being able to produce the homogeneous magnetic field, said internal, main pole pieces being separated by a generally V-shaped space, said region subject to the homogeneous magnetic field facing the opening of the V.

3. Structure according to claim 2, **characterized in that** an auxiliary, magnetic, polarization source (85) not aligned with the two aligned magnetic sources (21, 22) is located in the V-shaped space, said internal, main pole pieces (23, 24) and the auxiliary magnetic source (85) producing a controlled magnetic field in said region.

4. Structure according to claim 3, **characterized in that** a pole piece (86) is associated with the auxiliary magnetic source (85) and has a shape designed so as to control the magnetic field produced.

5. Device permitting the analysis of a given region by means of magnetic fields, **characterized in that** it comprises a structure according to any one of the claim 1 to 4 for producing an intense, static, homogeneous magnetic field in said given region, and means (8, 20, 25, 37, 38, 39, 63, 87, 88) permitting the emission of an electromagnetic signal to said given region and the reception of the response signal from said given region to the emitted signal.

6. Device according to claim 5, **characterized in that** the emission and reception means are constituted by at least one antenna placed in said V-shaped space.

7. Device according to claim 5, **characterized in that** the antenna is formed from an electrically conductive wire (30) and is stiffened by an amagnetic material.

8. Device according to claim 6, **characterized in that** the antenna (45) is formed from a channel-shaped portion (46) closed at one of its ends by an element (47), to which is connected a strip (48), the free end (44) of the channel and the free end (43) of the strip forming the electrical connections of the antenna.

9. Device according to any one of the claims 5 to 8, **characterized in that** it comprises an electromagnetic screen (9, 82, 83) between the antenna (8, 87, 88) and the adjacent pole piece or pieces (5, 6, 23, 24, 86) and optionally said auxiliary magnetic source (85).

10. Device according to claim 9, **characterized in that** the electromagnetic screen is formed from an electrically conductive sheet (40).

11. Device according to any one of the claims 5 to 10, **characterized in that**, for use as a surface magnetic imaging device, it comprises in the V-shaped space, gradient coils (64) for the directions in space x, y and possibly z, z being the direction of the homogeneous magnetic field in the given region.

12. Device according to claim 11, **characterized in that** it also comprises means (65, 66) for correcting the magnetic induction in the given region, said correction means being located in the V-shaped space.

13. Device according to either of the claims 11 or 12, **characterized in that** it has means (73) for the displacement of the magnetic structure for producing the induction gradient in the direction z.
